# EUROPEAN PATENT APPLICATION

(11) **EP 2 221 752 A1**
(43) Date of publication of application: **25.08.2010**
(21) Application number: 09305165.4
(22) Date of filing: 19.02.2009
(51) Int. Cl.: G06K 19/077

(54) **Microprocessor mini-card and its manufacturing process**

(71) Applicant: Gemalto SA, 92190 Meudon (FR)
(72) Inventor: Fidalgo, Jean-Christophe, 92197, MEUDON CEDEX (FR); Ottobon, Stéphane, 92197, MEUDON CEDEX (FR); Valette, Laurent, 92197, MEUDON CEDEX (FR)
(74) Representative: Fragnaud, Aude

(57) **Abstract**

The invention relates generally to microprocessor cards and their process of manufacturing. It relates more particularly to microprocessor mini-cards, such as mini-cards of the type SD, or micro-SD, or MMC, or plug-in, or mini-UICC or memory sticks etc...The method of manufacturing a microprocessor mini-card according to the invention comprises the step of transfer molding a resin (27) onto the component face (23) of a tape (20), for simultaneously encapsulating components (24) and connections (25), and forming the card body, and the step of cutting the transfer-molded resin (27) and the tape (20), in order to obtain a mini-card having dimensions compliant with standardized tolerances.

## Description

### BACKGROUND

This invention relates generally to microprocessor cards and their process of manufacturing.

It relates more particularly to microprocessor mini-cards, such as mini-cards of the type SD, or micro-SD, or MMC, or plug-in, or mini-UICC or memory sticks , or the like ...

Such mini-cards can be manufactured by using different conventional process. One of these conventional processes, described in European patent EP0 869 452, consists in using a transfer molding resin, which is molded in only one-step, for achieving two functions. The first function is forming an encapsulation resin in order to protect the component(s) and the connections against environmental stresses, while the second function consists in forming the card body itself. The transfer molding process enables to protect the chip by adhesion of the resin transfer on the leadframe. The resin transfer hardens and forms a protection or encapsulation for the component(s) and connections, while forming also simultaneously a geometrical shape of the card body of the mini chip-card. Such process is advantageous because it enables to form the card body and to protect the components and connections in only one-step, thus reducing the number of steps and the manufacturing costs.

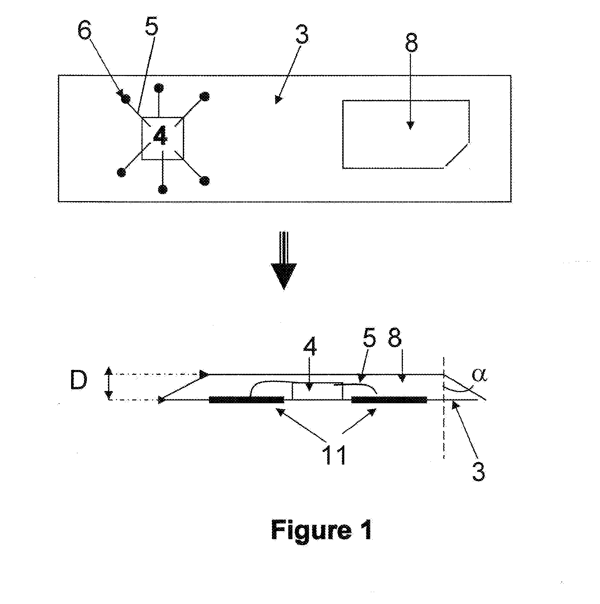

Such process of manufacturing and obtained mini-cards are illustrated in the schematic drawing of figure 1. This figure shows a carrier film 3, whose one face carriers a component 4, such as an IC chip for example, which is electrically connected to contact terminals 11 provided on the other face of the carrier film 3. The electrical connections are made for example by means of wire bonding 5 through apertures 6 created through the carrier film 3. Then, a resin 8 is applied onto the face carrying the component(s) 4 and connections 5, by transfer molding, in order to encapsulate and protect the components 4 together with the electrical connections 5, and to form the mini chip-card body simultaneously. In the illustrated example, the transfer-molded resin 8 is applied to form a card body of plug-in format ID-000.

However, in the known process, for the molding step, draft angles are necessary to allow package extraction out of the mold. Because of those draft angles, the differences between dimensions at the front face and the rear face of the card are too much important to stay within standardized tolerances. Indeed, for the plug-in card of figure 1 for example, the minimum draft angles α that can currently be obtained are no less than 30°. Such angles are too much important because, with the standardized thickness D of 0,76mm for such plug-in format, the difference of the length between the front face of the card (i.e. the contact face) and the rear face of the card (i.e. the transfer-molded resin face) is more than 0,6 mm, which is much more than the standardized tolerances of +/- 0,1 mm. In fact, for being compliant with the standardized tolerances, the draft angles should be less than 5°, and up to now, this is impossible to achieve by transfer molding.

Considering the above, a problem intended to be solved by the invention, is to propose a method of manufacturing a microprocessor mini-card comprising the step of transfer molding a resin for simultaneously encapsulating components and connections and forming the card body, said method enabling to control the dimensions of the card body thus obtained in order to be compliant with the standardized tolerances.

### SUMMARY

The solution of the invention to this problem relates to the fact that the method further comprises the step of cutting the transfer-molded resin and the tape, in order to obtain a mini-card having dimensions compliant with standardized tolerances.

Thus, the transfer-molded resin is molded onto the tape carrying component(s) and electric connections, in such a manner that its length and width are at least equal to the standardized dimensions of the card to be produced. Then, the molded resin and the tape are cut together, in order to obtain standardized dimensions on front and rear surfaces of the card, with angles very low between the two surfaces so that the obtained card body is compliant with standardized tolerances.

The cutting step can be made by any conventional cutting process such as mechanical punching, milling water jet, or laser for example.

Advantageously, the manufacturing process is made in continuous manner, by using a reel-to-reel tape. Moreover, the tape holds sprocket holes for displacing the tape between the reels and those sprocket holes are used to registrate the cutting of the molded resin.

According to another aspect of the invention, other problems occur during the cutting step of the transfer-molded resin. In fact, for the creation of contact terminals, by electroplating, tracks are provided to put these contacts at a predetermined potential. However, during the cutting step, these tracks, made with copper for example, are delaminated from the dielectric tape which creates a visual defect or even a functional defect if short cut is created between the delaminated tracks; and tracks are not cut as well as the dielectric tape and the molded resin, so that some burrs appear, which create a sharp edge not acceptable for manual handling.

Consequently, a second technical problem appears when cutting the transfer-molded resin. This second problem intended to be solved, is to propose a method of manufacturing a microprocessor mini-card comprising the step of transfer molding a resin for simultaneously encapsulating components and connections and forming the card body, said method first enabling to control the dimensions of the card body thus obtained in order to be compliant with the standardized tolerances, and second preventing any damage involved by the tracks during the cutting step.

The solution of the invention to this second problem relates to the fact that for the step of creation of contact terminals, tracks are provided to put said contacts at a predetermined potential, said tracks being processed in such a manner that they do not disturb the last cutting step.

In a first embodiment, during the step of creation of a pattern, tracks are provided on the component side, opposite to the side of the tape carrying the contact terminals, so that said tracks are encapsulated by molded resin, with the component and connections.

In a second embodiment, before the step of creation of the contact terminals, by electroplating, tracks are provided on the same side than the contact terminals, while said at least one component is attached on the other side, and at any stage between the electroplating step and the cutting step, said tracks are removed by etching.

According to another aspect, the invention relates also to a microprocessor mini-card comprising :
- a carrier film carrying contact terminals of the card on one side, and at least one component electrically connected to contact terminals via electric connections,
- molded packaging made of transfer-molded resin, through which component and electric connections are encapsulated, said molded packaging defining the final shape of the mini-card,
**characterized in that** the edges of the molded packaging are cut, so that dimensions of the mini-card are compliant with standardized tolerances.

### BRIEF DESCRIPTION OF DRAWINGS

Other particularities and advantages of the invention will be better understood with the help of the description below, which has been provided as an illustrative and non limitative example by reference to the enclosed figures that represent:
Figure 1, already described, is a schematic view of mini chip-card obtained by transfer molding a resin according to prior art,
Figures 2A and 2B, are schematic cross-sectional views of two examples of mini-cards manufactured according to the invention, during there manufacturing process,
Figures 3A and 3B, are respectively a schematic front view and a schematic rear view of a carrier film of a mini card of the invention before its encapsulation by transfer molding a resin,
Figure 4, is a schematic front view of a tape carrying several mini-cards during their manufacturing process.

### DETAILED DESCRIPTION

Hereafter, an embodiment of the invention will be described in the context of SIM card, with the plug-in format ID-000. Such card, as well as mini-plug-in UICC, complies with ISO standard 7810 and 7816. However, it is to be understood that the invention is usable for any microprocessor mini-cards, such as SD cards, micro-SD cards, MMC cards, mini-UICC cards, memory sticks cards, or the like etc....Cards of the type multimedia such as SD or MMC comply respectively with SD or MMC specifications available from SD or MMC associations.

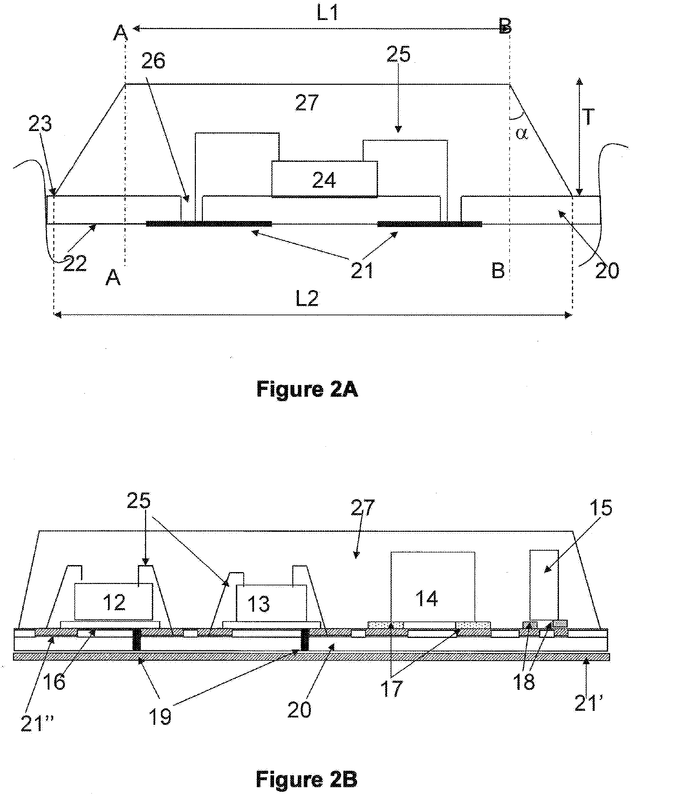

Figure 2A shows a tape 20, which is displaced between reels (not shown) during the manufacturing process. This tape comprises a contact face 22, onto which are provided contact terminals 21 for each card to be produced. The other face 23 of the tape, opposite to the contact face, carries at least one component. In the illustrated example, the component face 23 carries an IC chip 24, which is electrically connected to contact terminals 21 of the contact face 22 by means of wire bonding 25 through holes 26 provided through the thickness of the tape 20. Component(s), such as silicon chips and/or passive components, such as capacitor, resistance, inductance, resonators, are attached to the tape using a gluing process by means of a conductive or insulative glue. Electrical connections can be made, between some of the components and the tape, using either wire bonding of gold or aluminium or copper, or a flip chip process.

In a further step, the component(s) 24 and electric connections 25, 26 are protected against environmental stresses by means of a resin 27. This resin is applied by transfer-molding onto the component face 23. The molded shape of this transfer-molded rein 27 is close to the final shape of the mini-card to be produced.

A big advantage brought by this type of molding is that the available volume for embedding the components 24 and connections 25 is significantly increased compared to a usual module design using a glop top encapsulation resin or a reinforced UV curable resin.

However, for the transfer-molding step, important draft angles α are necessary to allow package extraction out of the mold. If, for example, the tape has a thickness of 200µm, the remaining thickness T of the molding has to be of 560µm, in order to achieve the standardized thickness D of 0,76mm of such plug-in. Because of those important draft angles α, the differences between dimensions at the front face 22 and the rear face 23 of the card are too much important to stay within standardized tolerances. In fact, the minimum draft angles that can currently be obtained are not less than 30°. Such angles are too much important because, with the standardized thickness D of 0,76mm for such plug-in, the difference of the lengths L2 and L1, between respectively the front face 22 of the card (i.e. the contact face) and the rear face 23 of the card (i.e. the transfer-molded resin face) is more than 0,6 mm, which is much more than the standardized tolerances of +/- 0,1mm given by the ISO standard.

A last step of the manufacturing process then consists in cutting the resin 27 and the tape 20 around the molding, in order to get the final dimensions of the mini-card and to be compliant with the standardized tolerances. For that, the molding is cut along the dashed lines A-A and B-B, so that draft angles are considerably reduced, and differences between dimensions at the front face and at the rear face of the card are reduced in such a manner that they become compliant with the standardized tolerances.

Such cutting operation can be based on several known technologies such as, but not limited to, laser, mechanical punching, milling water jet etc...

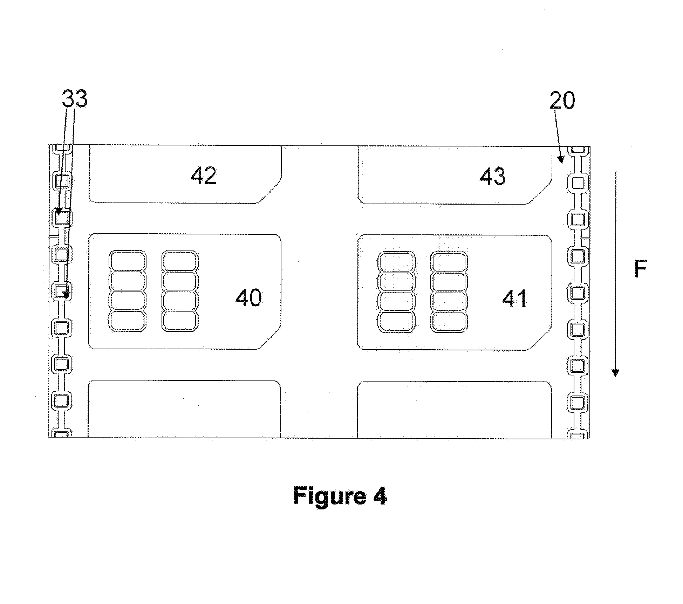

The tape 20 comprises lateral sprocket holes, referenced 33 in figure 4, that are commonly used for displacing the tape between the reels. Advantageously, these sprocket holes are also used during the cutting step for registration and accurate cutting around the molding.

The continuous process on a reel-to-reel tape brings some advantages. Amongst these advantages, it enables to perform other steps, using winding and unwinding of the tape between the reels, such as steps of testing and/or initializing and/or personalizing etc...

However, if some care is not performed during the manufacturing process of the mini-card, some problems occur during the cutting step of the molded resin and tape. These problems are linked to the tracks that are provided for creating the contact terminals.

In fact, the tape used can be based either on a single or double layer metal leadframe attached to a dielectric film. Such a double layer metal leadframe attached to a dielectric film 20 is exemplified on figure 2B, where reference 27 is the transfer-molded resin, reference 25 represents the wire bonding, reference 12 is for example a flash memory, while reference 13 is a controller, 14 a quartz and 15 a capacitor. Flash memory 12 and controller 13 are for example attached to the leadframe by means of insulative glue 16, while quartz 14 is electrically connected by means of silver glue, and capacitor 15 is connected via land patten 18. Metallized vias 19 enable to provide connections between the two metal layers 21' and 21 ".

The pattern comprising the contact terminals 21 onto the contact face 22 is made on the single or double metal layers using chemical etching or mechanical punching. To perform the plating of the contact terminals, an electroplating process is mandatory to get homogeneous thickness of the metal deposition. To perform this electroplating process, some copper tracks are required to put the pattern at a uniform predetermined potential. Those tracks are linked to the contact terminals 21 and are conventionally located on the same side of the tape, i.e. on the contact face 22. Usually, those tracks are going through the module perimeter, which will be cut.

However, when the molded resin and the tape are cut around the molding to get the final dimensions of the mini-card to be produced, those tracks are delaminated from the dielectric tape, thus creating a visual defect or even a functional defect if a short cut is created between the delaminated tracks. Moreover, those tracks are not cut as well as the dielectric tape and the resin, so that burrs appear, thus creating a sharp edge, which is not acceptable because the mini-card to be produced is designed to be manually handled and such sharp edge could cut the fingers of any person intended to handle this card, such as a manufacturing technician or the final user.

Consequently, tracks have to be processed in such a manner that they do not disturb the last cutting step and they prevent any damage of the cut mini-card.

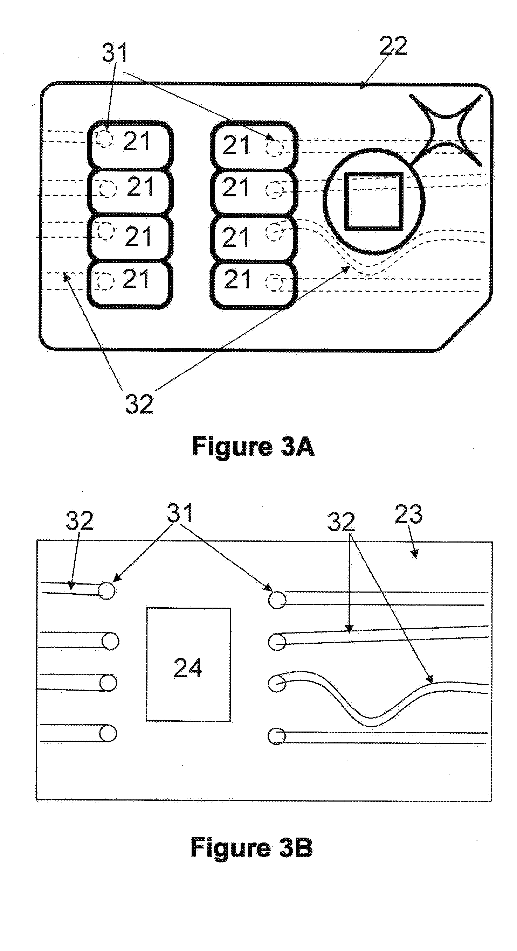

For that, a first embodiment, as illustrated in figure 3A and 3B, consists in placing the tracks 32 on the rear face of the tape, i.e. onto the components face 23. In that case, the tracks 32 are encapsulated into the transfer-molded resin 27 and the cutting is improved. The plating is still possible using through via holes 31 for connecting the tracks 32 to the contacts 21. Figure 3A shows the contact face 22 of the tape 20, which carries eight contact terminals 21. These contact terminals 21 are linked to the tracks 32 applied on the opposite side 23 using through via holes 31. Tracks 32 being onto the opposite side in figure 3A, they are drawn in dashed lines while they are drawn in continuous lines in figure 3B, which illustrates the components face 23 onto which they are provided.

A second embodiment, not illustrated, consists in removing the tracks that are conventionally applied onto the contact face 22, at any stage of the manufacturing process between the electroplating step of the contact terminals 21 and the last cutting step. Such removal can be made by etching, either by laser or mechanical etching or by chemical etching for example.

Figure 4 shows a tape 20 onto which are manufactured several mini-cards according to the manufacturing process of the present invention. The tape is a conventional tape used in the module manufacturing, it can be of 35 or 70 or 150 mm width. It comprises sprocket holes 33 used for the displacement of the tape between the reels. The sprocket holes are also advantageously used during the manufacturing process of the invention, for registering the tape during the cutting step, so as to be sure that the cutting is performed well around the molding to get the final dimensions of the mini-card, compliant with standardized tolerances.

The tape carries mini-cards 40, 41, 42, 43 manufactured by transfer molding a resin onto component face, so that resin enables first to protect components and electrical connections and second to obtain a shape close to the final shape of the mini-card to be produced. The sense of displacement is indicated by the arrow F. The molded cards 40 to 43 can then be tested, initialized, personalized etc... before being cut to get the final standardized dimensions of the card.

The final step of the manufacturing process consists in singulating all the mini-cards, by cutting them from the tape, around the molding, so that their dimensions comply with the standardized tolerances.

## Claims

1. Method of manufacturing a microprocessor mini-card comprising the steps of :
- using a reel to reel tape (20),
- for each mini-card to produce, creating a pattern on the tape, said pattern comprising contact terminals (21) on one side (22),
- attaching at least one component (24) on the tape and connecting said component to contact terminals (21) via electric connections (25),
- packaging said component (24) and connections (25) by using a transfer molding step, so as to first, protect the component(s) and connections and second, to define the dimensions of the mini-card, so that the packaging is close to the final shape of the mini-card to be produced,
**characterized in that** the method further comprises the step of cutting the transfer-molded resin (27) and the tape (20), in order to obtain a mini-card having dimensions compliant with standardized tolerances.

2. Method according to claim 1, wherein during the step of creation of a pattern, tracks (32) are provided on the component side (23), opposite to the side (22) of the tape carrying the contact terminals (21), so that said tracks are encapsulated by transfer-molded resin (27), with the component(s) (24) and connections (25).

3. Method according to claim 1, wherein before the step of creation of the contact terminals (21) by electroplating, tracks (32) are provided on the same side (22) than the contact terminals (21), while said at least one component (24) is attached on the other side (23), and at any stage between the electroplating step and the cutting step, said tracks (32) are removed by etching.

4. Method according to anyone of preceding claims, wherein cutting step is made by mechanical punching, milling water jet, or laser.

5. Method according to anyone of preceding claims, wherein the tape (20) holds sprocket holes (33) for displacing the tape between the reels and said sprocket holes (33) are used to registrate the cutting of the molded resin.

6. Microprocessor mini-card comprising :
- a carrier film (20) carrying contact terminals (21) of the card on one side (22), and at least one component (24) electrically connected to contact terminals (21) via electric connections (25),
- molded packaging made of transfer-molded resin (27), into which component(s) (24) and electric connections (25) are encapsulated, said molded packaging defining the final shape of the mini-card,
**characterized in that** the edges of the molded packaging are cut, so that dimensions of the mini-card are compliant with standardized tolerances.

7. Microprocessor mini-card according to claim 6, wherein carrier film (20) carries also tracks (32) on the component side (23) opposite to the contact terminals (21) side (22), said tracks (32) being encapsulated with said component(s) (24) and electric connections (25) into the transfer-molded resin (27).
